# EUROPEAN PATENT APPLICATION

(11) **EP 2 515 341 A2**
(43) Date of publication of application: **24.10.2012**
(21) Application number: 12164383.7
(22) Date of filing: 17.04.2012
(51) Int. Cl.: H01L 31/0224

(54) **ZnO-based transparent conductive thin film for photovoltaic cell and manufacturing method thereof**

(30) Priority: 22.04.2011 KR 20110037890
(71) Applicant: Samsung Corning Precision Materials Co., Ltd., Gyeongsangbuk-do Gumi-si, 730-735 (KR)
(72) Inventor: Kim, Seo Hyun, 336-841 Asan-si ChungCheongNam-Do (KR); Yoo, Young Zo, 336-841 Asan-si ChungCheongNam-Do (KR); Yoon, Gun Sang, 336-841 Asan-si ChungCheongNam-Do (KR); Choi, Eun-Ho, 336-841 Asan-si ChungCheongNam-Do (KR); Park, Taejung, 336-841 Asan-si ChungCheongNam-Do (KR)
(74) Representative: Gulde Hengelhaupt Ziebig & Schneider

(57) **Abstract**

A zinc oxide (ZnO)-based transparent conductive thin film for a photovoltaic cell and a manufacturing method thereof, in which the transparent conductive thin film has an excellent textured surface and can be mass-produced. The ZnO-based transparent conductive film is formed on a substrate, is doped with a dopant, and has a textured surface. The textured surface has a plurality of protrusions. The manufacturing method forms the zinc oxide-based transparent conductive film on a substrate by atmospheric pressure chemical vapor deposition (APCVD) involving organic precursor gas and oxidizer gas.

## Description

### CROSS REFERENCE TO RELATED APPLICATION

The present application claims priority from Korean Patent Application Number 10-2011-0037890 filed on April 22, 2011, the entire contents of which application are incorporated herein for all purposes by this reference.

### BACKGROUND OF THE INVENTION

### Field of the Invention

The present invention relates to a zinc oxide (ZnO)-based transparent conductive thin film for a photovoltaic cell and a manufacturing method thereof, and more particularly, to a ZnO-based transparent conductive thin film for a photovoltaic cell and a manufacturing method thereof, in which the transparent conductive thin film has an excellent textured surface and can be mass-produced.

### Description of Related Art

In general, in silicon (Si) thin-film photovoltaic cells, the light-absorbing layer of Si has a small light absorption coefficient. Accordingly, it is required that the path of incident light is lengthened by the scattering of the light in the light-absorbing layer, thereby increasing the efficiency of photovoltaic cells. For this, in thin-film photovoltaic cells, a front electrode, which is made of a transparent conductive oxide (TCO), has a textured surface in order to increase the photoelectric conversion efficiency.

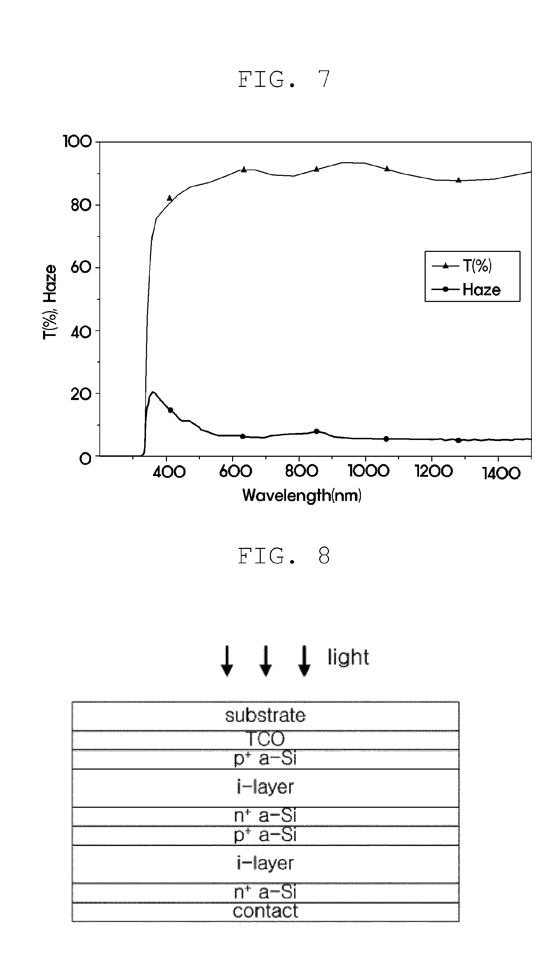

In currently used thin-film photovoltaic cells, front transparent electrodes are divided into a tin oxide (SnO₂) type and a zinc oxide (ZnO) type, depending on the materials that are used. Here, a SnO₂-based transparent conductive film has the drawback of being very poorly resistant to a hydrogen atmosphere. That is, the SnO₂-based transparent conductive film has a problem in that it is reduced by hydrogen plasma, whereby the transparency of the SnO₂-based transparent conductive film decreases. The hydrogen plasma is created in plasma-enhanced chemical vapor deposition (PECVD), which is the process of manufacturing a light-absorbing layer of a thin-film photovoltaic cell. This leads to a greater problem in the case of a Si tandem photovoltaic cell (see Fig. 8), the technical development of which has accelerated since it is easy to increase the efficiency thereof. In contrast, the ZnO-based transparent conductive film has excellent resistance to hydrogen plasma reduction and excellent electro-optical properties. The ZnO-based transparent deductive film is being studied for the purpose of replacing tin oxide (SnO₂), which is used in thin-film Si photovoltaic cells.

Meanwhile, atmospheric pressure chemical vapor deposition (APCVD), which is used for the manufacture of a ZnO-based transparent conductive film, is suitable for mass production due to its rapid coating rate and high productivity. However, APCVD has problems in that the stability and the processing of organic precursors have not yet been realized. When forming a ZnO-based transparent conductive film by sputtering, a thick ZnO-based transparent conductive film is deposited first, and texturing is then performed on the deposited transparent conductive film via wet etching. Therefore, this process, which is divided into the two steps, is limited in its usefulness in mass-producing the ZnO-based transparent conductive film.

The information disclosed in this Background of the Invention section is only for the enhancement of understanding of the background of the invention, and should not be taken as an acknowledgment or any form of suggestion that this information forms a prior art that would already be known to a person skilled in the art.

### BRIEF SUMMARY OF THE INVENTION

Various aspects of the present invention provide a zinc oxide (ZnO)-based transparent conductive thin film for a photovoltaic cell and a manufacturing method thereof, in which the transparent conductive thin film has an excellent textured surface and can be mass-produced.

In an aspect of the present invention, provided is a zinc oxide (ZnO)-based transparent conductive film for a photovoltaic cell. The ZnO-based transparent conductive film is formed on a substrate, is doped with a dopant, and has a textured surface. The textured surface has a plurality of protrusions. The cross-sectional contour of the protrusions forms an arc, or an obtuse angled vertex.

In an exemplary embodiment, the cross-sectional contour of the protrusion may form the arc in the direction in which the protrusion protrudes.

In an exemplary embodiment, the cross-sectional contour of the protrusion may form two sides of a triangle in the direction in which the protrusion protrudes.

In an exemplary embodiment, the obtuse angle may range from 100° to 150°.

In an exemplary embodiment, the cross-sectional contour of the protrusion is configured such that the ratio of the height to the length of the base may range from 0.3 to 0.7.

In an exemplary embodiment, the textured surface may have a plurality of projections on the plurality of protrusions. The projections are smaller than the protrusions.

In an exemplary embodiment, the longer side of the projections may range from 5nm to 15nm.

In an exemplary embodiment, the ZnO-based transparent conductive film may have a haze value ranging from 5% to 30% in the visible light wavelength band.

In an exemplary embodiment, the ZnO-based transparent conductive film may be formed on the substrate by atmospheric pressure chemical vapor deposition (APCVD).

In another aspect of the present invention, also provided is a method of manufacturing a ZnO-based transparent conductive film for a photovoltaic cell. The ZnO-based transparent conductive film is formed on a substrate by APCVD with organic precursor gas and oxidizer gas, and has a textured surface. The textured surface has a protrusion having the above-described shape.

In an exemplary embodiment, the APCVD includes the steps of: loading the substrate into a process chamber; heating the substrate; introducing the organic precursor gas into the process chamber; and introducing the oxidizer gas into the process chamber.

In an exemplary embodiment, the substrate may have a temperature ranging from 170°C to 600°C.

In an exemplary embodiment, the organic precursor gas may be a mixture of one or a combination of at least two selected from the group consisting of dimethyl zinc (DMZ), diethyl zinc (DEZ), zinc acetate and zinc acetoacetate, and a hydrocarbon.

In an exemplary embodiment, the oxidizer gas may be one or a combination of at least two selected from the group consisting of water (H₂O), methanol (CH₃OH), ethanol (C₂H₂O), butanol (C₄H₉OH), propanol (C₃H₈O), hydrogen peroxide (H₂O₂), oxygen (O₂) and ozone (O₃).

In an exemplary embodiment, the method may further include the step of doping the ZnO-based transparent conductive film with a dopant during or after the APCVD.

Here, the dopant may be one or a combination of at least two selected from the group consisting of gallium (Ga), boron (B), fluorine (F) and aluminum (Al).

In an exemplary embodiment, the dopant may be added in a content ranging from 0.5wt% to 10wet% of the amount of the ZnO-based transparent conductive film.

According to embodiments of the invention, it is possible to form an excellent textured surface of the ZnO-based transparent conductive film by an APCVD reaction with an organic precursor and an oxidizer. This also makes it possible to increase productivity, because the process is simplified.

According to embodiments of the invention, it is possible to manufacture the ZnO-based transparent conductive film that has a high haze value, is thin, and has a low specific resistance by forming the textured surface that has uniform structures in size and shape.

In addition, the ZnO-based transparent conductive film can be used as a transparent conductive film for a variety of types of photovoltaic cells including, for example, thin-film photovoltaic cells.

The methods and apparatuses of the present invention have other features and advantages which will be apparent from, or are set forth in greater detail in the accompanying drawings, which are incorporated herein, and in the following Detailed Description of the Invention, which together serve to explain certain principles of the present invention.

### BRIEF DESCRIPTION OF THE DRAWINGS

FIG. 1 is a cross-sectional view schematically depicting a zinc oxide (2nO)-based transparent conductive film for a photovoltaic cell according to an embodiment of the invention;

FIG. 2A, FIG. 2B and FIG. 2C are cross-sectional views schematically depicting the shape of protrusions formed on the ZnO-based transparent conductive film for a photovoltaic cell according to an embodiment of the invention;

FIG. 3 is a micrograph of the cross-section of a ZnO-based transparent conductive film for a photovoltaic cell, which is manufactured according to an embodiment of the invention, obtained using scanning electron microscopy (SEM);

FIG. 4 and FIG. 5 are micrographs of the surface of ZnO-based transparent conductive films for a photovoltaic cell, which are manufactured according to embodiments of the invention, obtained using SEM; and

FIG. 6 and 7 are graphs depicting variation in the transmittance and haze value depending on the wavelength of ZnO-based transparent conductive films for a photovoltaic cell, which are manufactured according to embodiments of the invention.

Fig. 8 shows a photovoltaic cell.

### DETAILED DESCRIPTION OF THE INVENTION

Reference will now be made in detail to various embodiments of the present invention, examples of which are illustrated in the accompanying drawings and described below, so that a person having ordinary skill in the art to which the present invention relates can easily put the present invention into practice.

In the following description of the present invention, detailed descriptions of known functions and components incorporated herein will be omitted when they may make the subject matter of the present invention unclear.

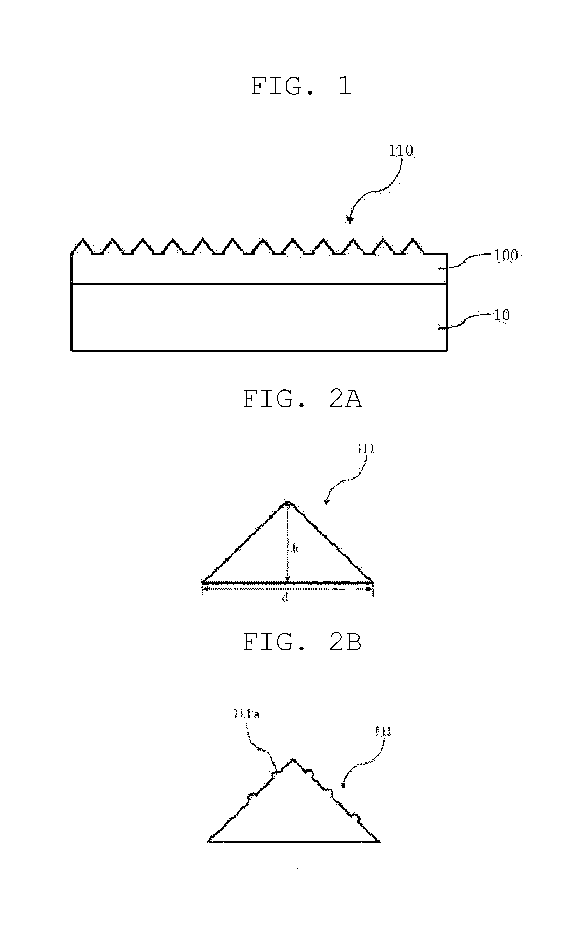

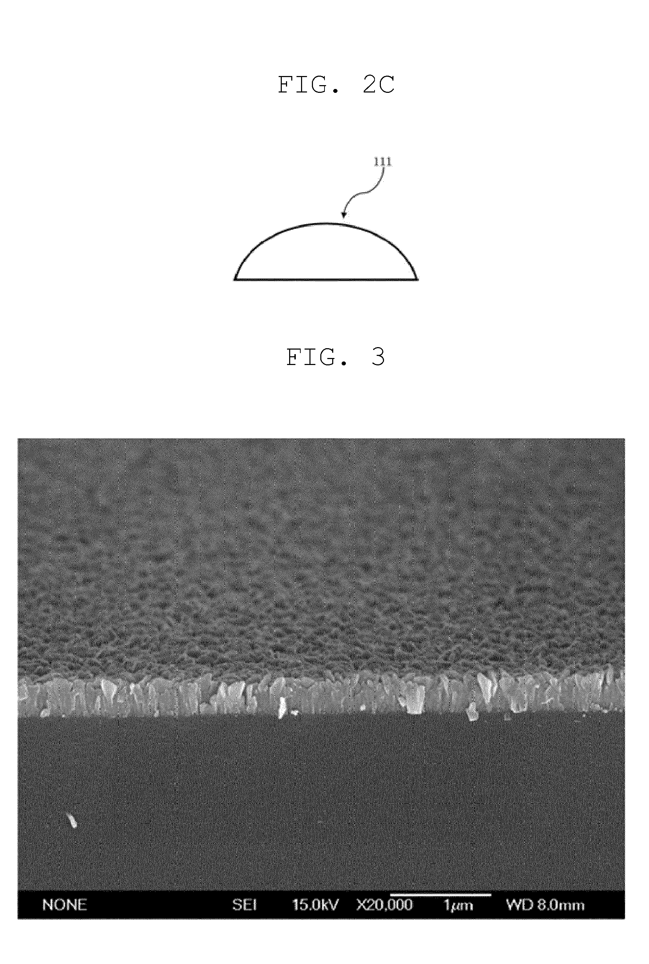

With reference to FIG. 1, FIG. 2A, FIG. 2B and FIG. 2C, a description will be given below of a ZnO-based transparent conductive film 100 according to an embodiment of the invention. The ZnO-based transparent conductive film 100 of this embodiment is formed on a substrate 10. The ZnO-based transparent conductive film 100 formed on the substrate 10 may have a thickness ranging from 300nm to 800nm. The ZnO-based transparent conductive film 100 is doped with a dopant. The ZnO-based transparent conductive film 100 also has a textured surface 110. The ZnO-based transparent conductive film 100 may be formed on the substrate 10 via low pressure chemical vapor deposition (LPCVD) or atmospheric pressure chemical vapor deposition (APCVD). It is preferred that the ZnO-based transparent conductive film 100 be formed on the substrate 10 via APCVD.

The substrate 10 is a transparent substrate that may be selected from any transparent substrates, as long as they have excellent light transmittance and excellent mechanical properties. For example, the transparent substrate can be made of a polymeric material, such as a thermally curable organic material or an ultraviolet (UV)-curable organic material, or chemically tempered glass, such as sodalime (SiO₂-CaO-Na₂O) glass or aluminosilicate (SiO₂-Al₂O₃-Na₂O) glass. The amount of Na may be adjusted depending on the application. The dopant that is used in order to increase the conductivity of the ZnO-based transparent conductive film 100 may be one or a combination of at least two selected from among, but not limited to, gallium (Ga), boron (B), fluorine (F) and aluminum (Al). The dopant may be added in a content ranging from 0.5wt% to 7wt% of the amount of the ZnO-based transparent conductive film 100. In addition, the dopant may be doped while the ZnO-based transparent conductive film 100 is being formed, or after the ZnO-based transparent conductive film 100 is formed. These will be described further in the following description of a method of manufacturing the ZnO-based transparent conductive film.

In addition, the textured surface 110 having uniform structures in size and shape is formed on the ZnO-based transparent conductive film 100. The textured surface 110 serves to lengthen the path of incident light in the ZnO-based transparent conductive film 100 by scattering the light, thereby increasing the photoelectric conversion efficiency of a photoelectric cell. Here, the textured surface 110 has protrusions 111, the size of the bottoms of which ranges from 120nm to 300nm.

Referring to the cross-section of the protrusion 111, as shown in FIG. 2A, the protrusion 111 may be configured such that the angle formed by two sides about the vertex is an obtuse angle, and more preferably, an angle ranging from 100° to 150°. FIG. 2A shows an example of a protrusion that has a triangular cross-section in the direction in which it protrudes. In the cross-section of the protrusion, the ratio of the height h to the base d may range from 0.3 to 0.7.

As shown in FIG. 2B, the textured surface 110 may have a plurality of projections 111a. The longer side of the projections 111a may range from 5nm to 15nm. The projections 111a serve to increase the amount of hazing in the short wavelength range. Due to the plurality of projections 111a that protrude from the textured surface 110, the ZnO-based transparent conductive film 100 exhibits a haze value that preferably ranges from 5% to 30% in the 600nm wavelength, i.e. a visible light wavelength. It is also possible to realize a haze value up to a maximum of 60% by controlling the size and the number of the projections 111a, although the value may be disadvantageous.

As shown in FIG. 2C, the protrusion 111 of the textured surface 110 may have a cross-sectional contour that forms an arc. Like a protrusion that forms two sides of a triangle, this protrusion may also have a plurality of projections 111a formed on the surface thereof.

A description will be given below of the method of manufacturing the ZnO-based transparent conductive film according to an embodiment of the invention.

In the method of manufacturing the ZnO-based transparent conductive film of this embodiment, the ZnO-based transparent conductive film 100 is formed on the substrate 10 by carrying out an APCVD reaction of zinc (Zn) precursor gas and oxidizer gas. When the ZnO-based transparent conductive film 100 is formed on the substrate 10 by the APCVD reaction of the Zn precursor gas and the oxidizer gas, the textured surface 110 having the protrusion 111, which is configured as described above, is spontaneously formed on the ZnO-based transparent conductive film 100. This can replace the two-step process of the related art, in which the ZnO transparent conductive film is deposited by sputtering, after which wet etching is then carried out in order to form the textured surface, with a one-step process, thereby helping realize mass production.

This APCVD process may include the steps of, for example, loading the substrate, heating the substrate, introducing the organic precursor gas, and introducing the oxidizer gas, carried out in that sequence.

First, in the step of loading the substrate, the substrate 10 is loaded into a process chamber (not shown) in which the APCVD reaction will be carried out. The substrate 10 is placed in position inside the process chamber.

In the next step of heating the substrate, the substrate 10, which have been loaded into the process chamber (not shown) is heated to a predetermined temperature. In the heating step, the substrate 10 is heated to a temperature ranging from 170°C to 600°C.

Sequentially, in the step of introducing the organic precursor gas, the organic precursor gas is introduced into the process chamber (not shown) in order to deposit ZnO-based transparent conductive film 100 on the substrate. The organic precursor may be a mixture of one or a combination of at least two selected from among dimethyl zinc (DMZ), diethyl zinc (DEZ), zinc acetate and zinc acetoacetate, which are substances that are stable at atmospheric temperature, and a hydrocarbon, such as hexane, heptane, or octane. The organic precursor may be carried by a carrier gas, which is composed of an inert gas such as nitrogen, helium or argon, into the process chamber (not shown).

In the final step of introducing the oxidizer gas, the oxidizer gas is introduced into the process chamber (not shown) for an APCVD reaction with the precursor gas. The oxidizer may be one or a combination of at least two selected among from, but not limited to, water (H₂O), methanol (CH₃OH), ethanol (C₂H₂O), butanol (C₄H₉OH), propanol (C₃H₈O), hydrogen peroxide (H₂O₂), oxygen (O₂) and ozone (O₃).

The step of introducing the organic precursor gas and the step of introducing the oxidizer gas may both be carried out at the same time. In this case, it is preferred that the respective gases be controlled such that they are supplied along different paths in order to prevent the gases from mixing with each other before being introduced into the process chamber (not shown). In addition, the organic precursor gas and the oxidizer gas may be preheated before being supplied in order to activate the chemical reaction.

The method of manufacturing the ZnO-based transparent conductive film of this embodiment also includes the step of doping with a dopant in order to increase the conductivity of the ZnO-based transparent conductive film 100. The step of doping with the dopant may be carried out by inputting the dopant into the process chamber (not shown) during the APCVD, or by implanting ions after forming the ZnO-based transparent conductive film 100 on the substrate 10 through the APCVD. The dopant may be one or at least two selected from among, but not limited to, gallium (Ga), boron (B), fluorine (F) and aluminum (Al). In this case, it is preferred that the dopant be added in a content ranging from 0.5wt% to 10wt% of the amount of the ZnO-based transparent conductive film 100.

When the above-described process is completed, the ZnO-based transparent conductive film 100 according to an embodiment of the invention has been formed on the substrate 10. As can be seen from the micrographs obtained using scanning electron microscopy (SEM) shown in FIG. 3 to FIG. 5, the above-described protrusions 111 are spontaneously formed on the resultant ZnO-based transparent conductive film 100, such that they have a generally uniform size and shape. The ZnO-based transparent conductive film 100, which is manufactured according to an embodiment of the invention, is very thin tnanks to the APCVD and has a low specific resistance.

The protrusion 111 of the textured surface 110 may have a cross-section that forms two sides of a triangle or an arc. In the case of the triangular cross-section, the angle formed by two oblique sides about the vertex is an obtuse angle. In addition, a plurality of projections 111a may protrude from the surface of the protrusions 111.

**Table 1**

| Position | 1 | 2 | 3 | 4 | 5 | 6 | 7 | 8 | 9 | 10 |
|---|---|---|---|---|---|---|---|---|---|---|
| Angle (°) | 131 | 130 | 132 | 123 | 128 | 147 | 123 | 134 | 124 | 139 |

**Table 2**

| Position | 1 | 2 | 3 | 4 | 5 | 6 | 7 | 8 | 9 | 10 |
|---|---|---|---|---|---|---|---|---|---|---|
| Angle (°) | 112 | 108 | 113 | 102 | 115 | 111 | 115 | 111 | 125 | 108 |

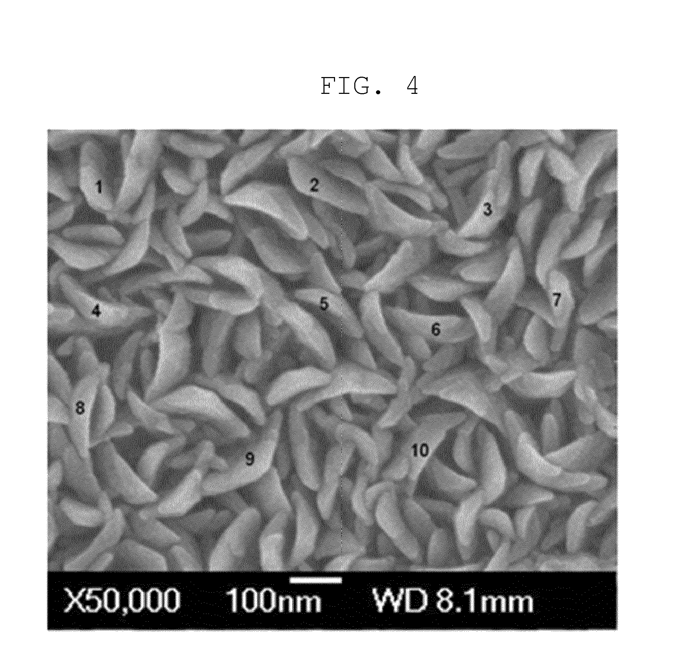

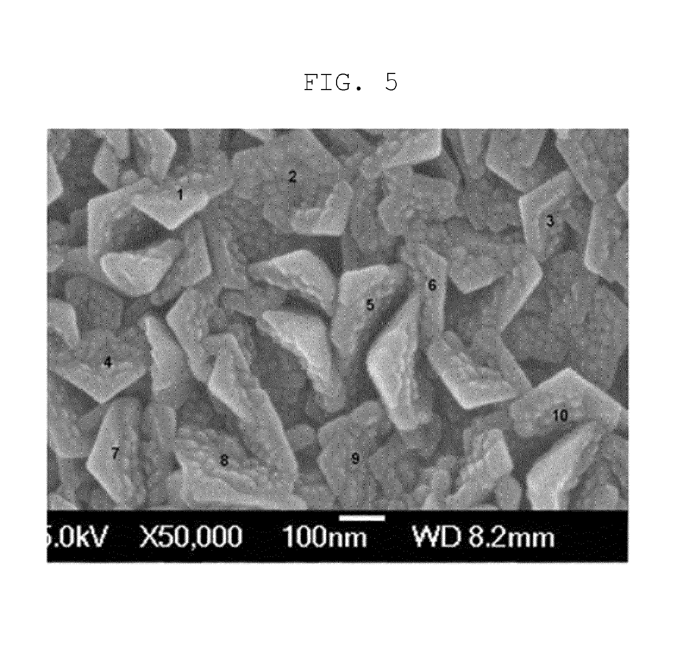

Table 1 and Table 2 present angles formed by two oblique sides about the vertex of the protrusions 111 shown in FIG. 4 and 5. It can be appreciated that the obtuse angles are formed by the two oblique sides about the vertex also in the textured surface 110 having the projections 111a (FIG. 5). FIG. 4 and FIG. 5 are micrographs of the surface of ZnO-based transparent conductive films for a photovoltaic cell, obtained using SEM, by varying process conditions.

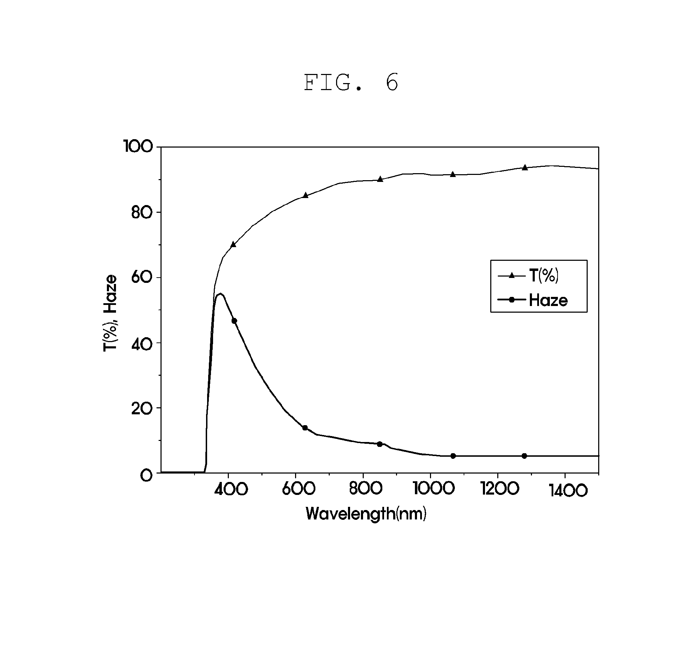

FIG. 6 and 7 are graphs depicting variation in the transmittance and haze value depending on the wavelength of ZnO-based transparent conductive films for a photovoltaic cell, which are manufactured according to embodiments of the invention. FIG. 6 is the graph depicting the result obtained by measuring the ZnO-based transparent conductive film 100 shown in FIG. 4, and FIG. 7 is the graph depicting the result obtained by measuring the ZnO-based transparent conductive film 100 shown in FIG. 5. As shown in FIG. 6 and FIG. 7, it was observed that the ZnO-based transparent conductive film 100, which was manufactured according to an embodiment of the invention, exhibited a relatively high haze value in the visible light range.

As set forth above, in the ZnO-based transparent conductive film 100 and the manufacturing method thereof, which are provided according to embodiments of the invention, it is possible to form the excellent textured surface 110 on the ZnO based transparent conductive film by the APCVD with an organic precursor and an oxidizer. This also makes it possible to increase productivity, because the process is simplified. Since the textured surface 110 having uniform structures in size and shape is spontaneously formed on the ZnO-based transparent conductive film 100 by the APCVD, the ZnO-based transparent conductive film 100 exhibits a high haze value. In addition, the ZnO-based transparent conductive film 100, which is manufactured according to embodiments of the invention, is very useful for the transparent conductive electrode of a variety of types of photovoltaic cells, such as thin-film photovoltaic cells.

The foregoing descriptions of specific exemplary embodiments of the present invention have been presented with respect to the certain embodiments and drawings. They are not intended to be exhaustive or to limit the invention to the precise forms disclosed, and obviously many modifications and variations are possible for a person having ordinary skill in the art in light of the above teachings.

It is intended therefore that the scope of the invention not be limited to the foregoing embodiments, but be defined by the Claims appended hereto and their equivalents.

## Claims

1. A zinc oxide-based transparent conductive film for a photovoltaic cell, the zinc oxide-based transparent conductive film being formed on a substrate, being doped with a dopant, and having a textured surface,
wherein the textured surface has a plurality of protrusions, a cross-sectional contour of each protrusion forming an arc or an obtuse angled vertex.

2. The zinc oxide-based transparent conductive film of claim 1, wherein the cross-sectional contour of each protrusion forms two sides of a triangle.

3. The zinc oxide-based transparent conductive film according to any one of the preceding claims, wherein the obtuse angle ranges from 100° to 150°.

4. The zinc oxide-based transparent conductive film according to any one of the preceding claims, wherein the cross-sectional contour of each protrusion is configured such that a ratio of a height to a length of a base ranges from 0.3 to 0.7.

5. The zinc oxide-based transparent conductive film according to any one of the preceding claims, wherein the textured surface has a plurality of projections which are formed on the plurality of protrusions and are smaller than the plurality of protrusions.

6. The zinc oxide-based transparent conductive film of claim 5, wherein a longer side of the plurality of projections ranges from 5nm to 15nm.

7. The zinc oxide-based transparent conductive film according to any one of the preceding claims, having a haze value ranging from 5% to 30% in a visible light wavelength band.

8. A method of manufacturing a zinc oxide-based transparent conductive film for a photovoltaic cell, comprising forming the zinc oxide-based transparent conductive film on a substrate by atmospheric pressure chemical vapor deposition (APCVD) with organic precursor gas and oxidizer gas.

9. The method of claim 8, wherein the atmospheric pressure chemical vapor deposition (APCVD) comprises:
loading the substrate into a process chamber;
heating the substrate;
introducing the organic precursor gas into the process chamber; and
introducing the oxidizer gas into the process chamber.

10. The method according to any one of claims 8 and 9, wherein the atmospheric pressure chemical vapor deposition (APCVD) is carried out in a state in which the substrate is heated to a temperature ranging from 170°C to 600°C.

11. The method according to any one of claims 8 to 10, wherein the organic precursor gas comprises a mixture of at least one selected from the group consisting of dimethyl zinc (DMZ), diethyl zinc (DEZ), zinc acetate and zinc acetoacetate, and a hydrocarbon; and/or wherein the oxidizer gas comprises at least one selected from the group consisting of water (H₂O), methanol (CH₃OH), ethanol (C₂H₂O), butanol (C₄H₉OH), propanol (C₃H₈O), hydrogen peroxide (H₂O₂), oxygen (O₂) and ozone (O₃).

12. The method according to any one of claims 8 to 11, further comprising doping the zinc oxide-based transparent conductive film with a dopant during or after the atmospheric pressure chemical vapor deposition (APCVD).

13. The method of claim 12, wherein the dopant comprises at least one selected from the group consisting of gallium (Ga), boron (B), fluorine (F) and aluminum (Al).

14. The method according to any one of claims 12 and 13, wherein the dopant is added in a content ranging from 0.5wt% to 10wt% of an amount of the zinc oxide-based transparent conductive film.

15. The method according to any one of claims 8 to 14, wherein the zinc oxide-based transparent conductive film is doped with a dopant, and has a textured surface,
the textured surface having a plurality of protrusions, a cross-sectional contour of each protrusion forming an arc or an obtuse angled vertex.
